Europäisches Patentamt

**European Patent Office**

**Office européen des brevets**

(19)

(11) Numéro de publication : **0 128 105**
**B1**

(12)

# FASCICULE DE BREVET EUROPÉEN

(45) Date de publication du fascicule du brevet :
09.09.87

(51) Int. Cl.⁴ : **H 04 N 11/18, H 03 C 3/22**

(21) Numéro de dépôt : **84440024.2**

(22) Date de dépôt : **29.05.84**

(54) **Système codeur couleur SECAM pour application grand public.**

(30) Priorité : **01.06.83 FR 8309218**

(43) Date de publication de la demande :
**12.12.84 Bulletin 84/50**

(45) Mention de la délivrance du brevet :
**09.09.87 Bulletin 87/37**

(84) Etats contractants désignés :
**AT BE CH DE GB IT LI LU NL SE**

(56) Documents cités :
**FR-A- 2 371 111**
**US-A- 3 544 919**

(73) Titulaire : **C G V Compagnie Générale de Vidéotechnique**
**8 rue Alexandre Dumas**
**F-67200 Strasbourg (FR)**

(72) Inventeur : **Grandmougin, Gérard**
**16 rue Schwendi**
**F-67000 Strasbourg (FR)**

(74) Mandataire : **Armengaud Ainé, Alain**
**Cabinet ARMENGAUD AINE 3 Avenue Bugeaud**
**F-75116 Paris (FR)**

**Description**

La présente invention porte sur un codeur SECAM composé d'un circuit générateur de la sous-porteuse CHROMA et d'un circuit de traitement du signal de luminance. Des montages de ce type sont déjà connus et utilisés mais le but de la présente invention est de proposer un montage nécessitant un nombre de composants réduit tout en étant suffisamment performant.

Ce but est atteint principalement en utilisant, dans le circuit générateur de la sous-porteuse CHROMA, un oscillateur à structure symétrique, dont la composition est décrite en détail ci-après. En outre, le montage comporte d'autres avantages :

— le signal CHROMA étant injecté dans le signal de luminance avant entrée dans un circuit anti-cloche de conception classique, le dit circuit anti-cloche filtre simultanément les deux signaux ce qui permet d'éviter l'emploi d'un filtre coupe-bande sur le signal de luminance,

— l'amplificateur utilisé dans le circuit générateur de la sous-porteuse CHROMA se caractérise par l'utilisation des caractéristiques d'une porte C. MOS pour supprimer le dépassement du domaine des fréquences prévu dans la définition du signal SECAM, et qui est causé par l'élément de préaccentuation.

L'invention sera mieux comprise à l'aide de la description ci-après d'un mode de réalisation non limitatif, faite en référence aux figures et dessins annexés pour lesquels :

la figure 1 est un schéma synoptique du mode de réalisation préféré,

la figure 2 est un schéma montrant en détails le circuit du mode de réalisation préféré, en correspondance avec le synoptique de la figure 1.

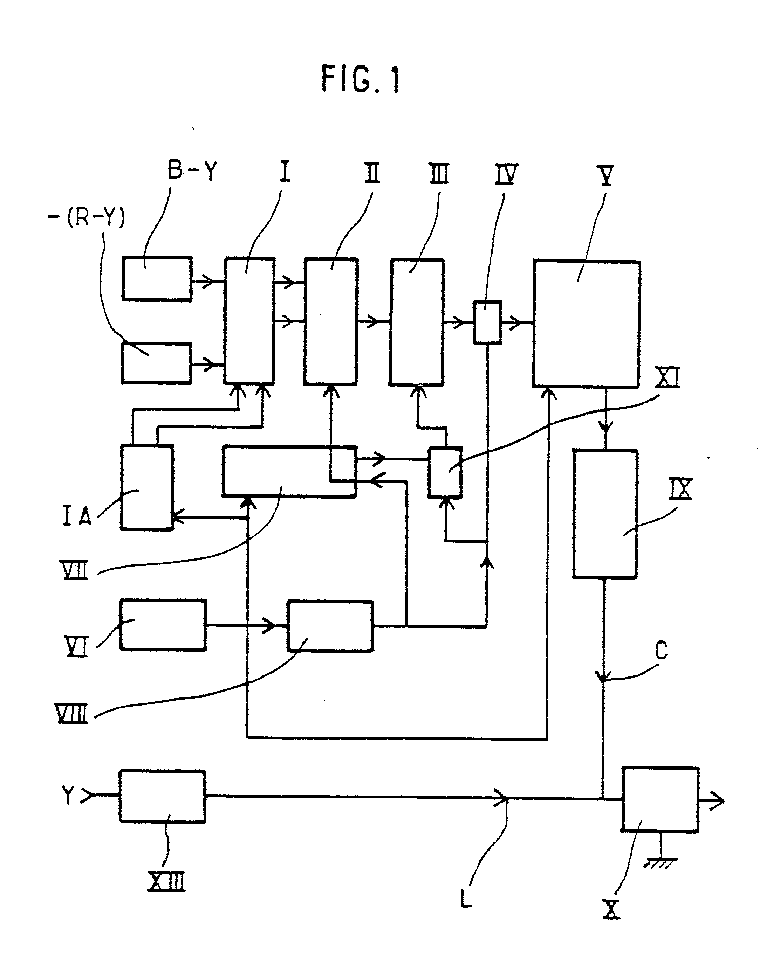

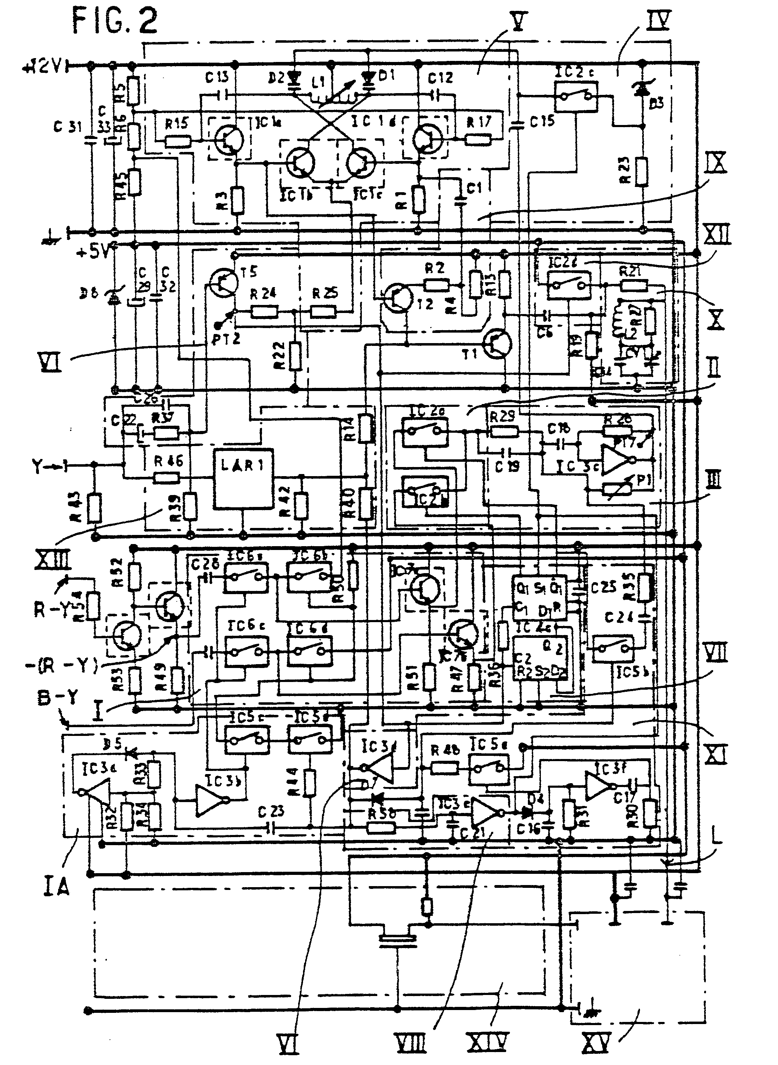

Selon un mode préféré de réalisation de l'invention, le codeur SECAM conforme à l'invention comporte principalement les éléments fonctionnels montés suivant le dispositif du synoptique de la figure 1 et suivant le montage représenté en détails à la figure 2.

Ledit codeur SECAM est constitué au moins d'un circuit générateur de la sous-porteuse CHROMA (C) et d'un circuit de traitement du signal de luminance (L).

Le circuit générateur de la sous-porteuse CHROMA (C) se compose, pour sa part, au moins des éléments suivants :

— un fixateur de niveau de tension (I) et son circuit de commande (IA)
— un permutateur (II)
— un amplificateur (III)
— un fixateur de niveau de tension (IV)
— un oscillateur (V)
— une source de courant (IX)
— un circuit anti-cloche (X)
— un séparateur des signaux de synchronisation (VI)
— un diviseur (VII)
— un séparateur des « top-trame » (VIII)
— un générateur des signaux d'identification trame (XI)
— un fixateur de niveau de tension (XII).

Dans l'ensemble de la description, on comprendra que l'expression : fixateur de niveau de tension désigne le circuit connu de l'homme du métier sous le terme « clamping ».

Selon l'organisation préférée du générateur de la sous-porteuse CHROMA (C) représenté en figure 1, le signal d'entrée appelé (B—Y) et le signal d'entrée (R—Y) entrent, après changement de signe du signal (R—Y), dans le montage (I) appelé fixateur de niveau de tension.

Ensuite les deux sorties du fixateur de niveau de tension (I) sont reliées à deux entrées du permutateur (II). La sortie du permutateur (II) est reliée à une entrée de l'amplificateur (III). Une sortie de l'amplificateur (III) est reliée à une entrée du fixateur de niveau de tension (IV), la sortie du fixateur de niveau de tension (IV) est reliée à une entrée de l'oscillateur (V). La sortie de l'oscillateur (V) est reliée à l'entrée du générateur de courant (IX). D'autre part la sortie du séparateur des signaux de synchronisation (VI) est reliée d'une part à une entrée du diviseur (VII), d'autre part à l'entrée du séparateur des top-trame (VIII), enfin à une entrée de l'oscillateur (V).

Une sortie du diviseur (VII) est reliée à une entrée du permutateur (II).

La sortie du séparateur (VIII) est reliée d'une part à une entrée du diviseur (VIII), d'autre part à une entrée du générateur des signaux d'identification trame (XI), et enfin à une entrée du fixateur de niveau de tension (IV). En outre une autre entrée du générateur des signaux d'identification trame (XI) est reliée à une sortie du diviseur (VII) et la sortie du dit générateur (XI) est reliée à une entrée de l'amplificateur (III).

Le signal référencé (C) en sortie du générateur de courant (IX) est le signal CHROMA présentant les caractéristiques recherchées. De préférence ce signal (C) est introduit dans le signal de luminance (L) avant entrée dans le circuit anti-cloche (X).

Le circuit de traitement du signal de luminance se compose uniquement d'un retardateur (XIII).

Les fonctions et avantages de chacun des éléments du synoptique sont décrits ci-après.

Le fixateur de niveau de tension (I) comprend un jeu de deux commutateurs successifs (IC6a) et (IC6b) pour le signal (R—Y) et un jeu de deux commutateurs successifs (IC6c) et (IC6d) pour le signal (B—Y) dans lesquels les commutateurs (IC6b) et (IC6d) restent fermés plus longtemps que les

2

**0 128 105**

commutateurs (IC6a) et (IC6c).

Ceci permet de:
— référencer chacun des signaux (B—Y) et —(R—Y) à une tension fixe
— éliminer certains signaux du micro-ordinateur indésirables dans les circuits de commande du codeur, c'est-à-dire assurer une fonction de nettoyage.

Les composants dudit fixateur de niveau de tension (I) sont montés selon détails de la figure 2 et comprennent :
— des commutateurs (logique et/ou analogique) encore appelés « SWITCH » (IC6a) (IC6b) (IC6c) (IC6d), du type CD 4066
— deux capacités (C 28) pour l'entrée —(R—Y) et (C 30) pour l'entrée (B—Y)
— deux transistors suiveurs (IC7a) et (IC7b) faisant fonction d'adaptateurs d'impédance.
— 2 résistances de polarisation R 51 et R 47
— une résistance R 50.

En outre, au circuit (I), on associe un circuit de commande (IA) des commutateurs du fixateur de niveau de tension (I). Ce circuit de commande est conçu de façon classique, selon le montage détaillé de la figure 2 et comprend :
— deux portes (IC3a), (IC3b) de type CD 4069
— une diode (D5)
— les résistances (R 32), (R 33), (R 34), (R 44)
— une capacité (C 23)
— deux commutateurs (IC5c) (IC5d) du type CD 4066.

Le permutateur (II) est constitué de deux commutateurs (IC2a) et (IC2b) du type CD 4066, sa conception classique est reprise sur le schéma de détails de la figure 2.

Les deux signaux de sortie du fixateur de niveau de tension (I) sont reçus dans les deux entrées du permutateur, à la sortie duquel on obtient alternativement l'un ou l'autre des signaux d'entrées.

L'amplificateur CHROMA (III) utilisé se caractérise par l'utilisation d'une porte C. MOS (IC3c) du type CD 4069 selon montage détaillé de la figure 2, il comporte en outre :
— une capacité (C 19), en parallèle sur une résistance (R 29), jouant un rôle de réaccentuation et sur laquelle entre le signal de sortie du permutateur (II)
— une capacité (C 18)
— une résistance variable (P 1)
— une résistance (R 28).

On utilise ainsi dans ce montage les limitations d'amplitude de sortie et de bande passante inhérente à la porte C. MOS. Ceci permet de supprimer le dépassement, amené par la préaccentuation, du domaine des fréquences prévues pour la définition du signal SECAM.

La limitation est approximative mais suffisante.

Le fixateur de niveau de tension (IV) permet de donner une tension continue de référence à l'oxcillateur (V), par la diode (D 3) et la résistance (R 23), or l'impédance d'entrée de l'oscillateur CHROMA étant infinie, il résulte une bonne efficacité du fixateur de niveau de tension.

Les éléments constitutifs du fixateur de niveau de tension (IV) sont montés selon le circuit détaillé de la figure 2 et comprennent :
— un commutateur (IC2c) du type CD 4066
— une capacité (C 15) recevant le signal de sortie de l'amplificateur (III)
— une diode zener (D 3) et la résistance (R 23).

L'oscillateur CHROMA (V) utilisé dans ce montage se caractérise par sa structure symétrique et par la possibilité de se laisser commander aussi bien en amplitude qu'en fréquence. Ceci a pour but d'obtenir :
— une faible interférence de chacun des signaux d'entrées sur les signaux de sortie
— possibilité avec une commande en amplitude, de supprimer la CHROMA quand elle est indésirable ou déterminer de façon précise l'amplitude de la CHROMA
— obtention d'un faible taux d'harmoniques et de signaux parasites à la sortie.

Les éléments constitutifs de l'oscillateur sont branchés ainsi que le représente la figure 2 et se composent de :
— deux diodes (D 2) et (D 1) pour recevoir le signal d'entrée de l'oscillateur, chacune étant reliée à une extrémité d'une bobine ajustable (L 1).
— une capacité (C 13) reliée d'une part à une extrémité de la bobine ajustable (L 1) et d'autre part à un transistor suiveur (IC1a), de même (C 12) est reliée d'une part à (L 1) et d'autre part à un transistor suiveur (IC1d).

Ainsi on amplifie par deux étages suiveurs les sorties de la bobine (L 1).

La charge du circuit oscillant est principalement résistive grâce à (R 15) et (R 17). En outre la résistance (R 3) polarise le transistor (IC1a) et (R 1) le transistor (IC1d).

Les systèmes suiveurs aboutissent sur une paire de transistors (IC1b) et (IC1c), qui commutent alternativement le courant traversant la résistance (R 25) sur une extrémité de la bobine (L 1) ou sur l'autre extrémité de ladite bobine (L 1).

Les conditions déterminant l'amplitude du signal de l'oscillateur sont : le courant dans la résistance (R 25), et les valeurs des résistances (R 15) et (R 17). On peut déduire l'importance de l'oscillation en

3

fonction du courant injecté dans la bobine (L 1).

En choisissant quatre transistors (IC1a), (IC1b), (IC1c), (IC1d) d'un même circuit intégré monolithique on obtient un bon équilibre entre les transistors.

Le séparateur des signaux de synchronisation (VI) est de conception classique.

Il se compose de :
— un transistor (T 5) polarisé par les résistances (R 24), (R 22), (R 25)
— deux capacités (C 26) et (C 22) en série avec (R 37)
— un inverseur (IC3d) du type CD 4069, ces éléments étant branchés selon le circuit détaillé de la figure 2.

Le diviseur (VII) est composé d'une double bascule (IC4a), une résistance (R 36), une capacité (C 25) branchées selon le circuit détaillé de la figure 2.

L'entrée du signal de sortie du synchronisateur (VI) se fait sur les entrées horloge (C1) et (C2) de la double bascule (IC4a).

Le diviseur (VII) réalise :
— une division de la fréquence par deux
— un retard du signal de la demi-fréquence ligne grâce à la résistance (R 36) sur l'entrée (C1) de la deuxième bascule
— bloque le permutateur (II) sur un signal donné par l'entrée SET (S1) sans décaler le comptage de la demi-fréquence ligne.

Le séparateur des « top-trame » (VIII) a pour fonction de séparer les signaux de synchronisation-trame, en intégrant le signal d'entrée.

Ledit séparateur (VIII) se compose d'une porte (IC3e), d'une résistance (R 38), d'une capacité (C 21) branchées selon détails de la figure 2.

Le générateur de courant (IX) est considéré comme la sortie de l'oscillateur symétrique. La sortie de l'oscillateur est faite par un générateur de courant qui ne dépend que de la différence de potentiel aux bornes de la bobine (L 1). Par ce montage on obtient une réjection totale des signaux parasites d'alimentation sur la sortie de l'oscillateur. Les composants du générateur (IX) à savoir :
— un transistor (T 2), deux résistances (R 2) (R 4) une capacité (C 1) sont branchés selon détails de la figure 2.

Le circuit anti-cloche (X) filtre simultanément le signal CHROMA (C) et le signal de luminance (Y), les signaux peuvent donc être mélangés sans précaution spéciale. La pureté des signaux obtenus évite l'emploi d'un filtre passe-bande sur le signal CHROMA (C).

Les composants du circuit anti-cloche (X) sont branchés selon détails de la figure 2 et se composent de : une self (L 2), deux résistances (R 27) et (R 21), une capacité (C 14) et une capacité variable (CV 1).

En outre le circuit anti-cloche (X) est associé à un fixateur de niveau de tension (XII) pour référencer le signal vidéo à la tension continue de 5 volts pour un montage classique comprenant un commutateur (IC2d), une capacité (C 6).

Le circuit générateur de signaux d'identification des « top-trame » (XI) se caractérise par le choix des composants et de leur montage, dans le but d'obtenir un fonctionnement suffisamment fiable avec un coût le plus faible possible. Le montage préféré non limitatif est indiqué en détails à la figure 2 et comprend les commutateurs (IC5a) (IC5b), les capacités (C 24), (C 27), (C 16), (C 17), les diodes (D 7) et (D 4), une porte (IC3f), les résistances (R 48) (R 31) (R 30) (R 35).

En outre le montage comprend un retardateur (XIII) du signal de luminance (Y) de composants (R 46), (R 39), (R 14), (R 40), (LAR 1), dont détails en figure 2, ainsi que divers éléments déterminés facilement par l'homme du métier. La nomenclature ci-après donne les valeurs numériques et les références de tous les éléments représentés sur le schéma de la figure 2.

En outre le codeur conforme à ce mode préféré de réalisation fonctionne avec un modulateur de son (XIV) et une platine modulateur (UHF (XV)) du même constructeur.

On ne sortira pas du cadre de l'invention en réalisant des variantes d'exécutions présentant des caractéristiques équivalentes.

Enfin, la solution apportée par l'exemple de réalisation non limitatif décrit ci-dessus, donne de bons résultats visuels tout en étant peu coûteuse (il y a moins de filtrage), en nécessitant peu de réglages ou ajustements, et en consommant peu.

On notera que l'homme du métier peut reproduire l'invention au vu du schéma de détails de la figure 2, une nomenclature est jointe :

| Référence | Désignation | Référence | Désignation |
|-----------|-------------|-----------|-------------|
| R 1 | 3K3 (Ω) | R 2 | 2K2 (Ω) |
| R 3 | 3K3 | R 4 | 4I7 |
| R 5 | 1K8 | R 6 | 560 |
| R 13 | 2I2 | R 14, R 13 | 2K2 |
| R 15 | 10K | R 17 | 10K |
| R 21 | IK | R 22 | 1K5 |

4

(Suite)

| Référence | Désignation | Référence | Désignation |
|---|---|---|---|
| R 23 | 1K5 | R 24 | 1K5 |
| R 25 | 75K | R 26 | |
| R 27 | 27K | R 28 | 10M |
| R 29 | 10K | R 30 | 820K |
| R 31 | 1M | R 32 | 100K |
| R 33 | 20K | R 34 | 36K |
| R 35 | 36K | R 36 | 100K |
| R 37 | 220 | R 38 | 27K |
| R 39 | 470K | R 40 | 100K |
| R 42 | 1K | R 43 | 75 |
| R 44 | 100K | R 45 | 240 |
| R 46 | 1K | R 47 | 4K7 |
| R 48 | 100K | R 49 | 10K |
| R 50 | 10K | R 51 | 4K7 |
| R 52 | 1K | R 53 | 820 |
| C 1 | 100n | C 6 | 100n |
| C 12 | 10n | C 14 | 10p |
| C 15 | 10n | C 16 | 270pF |
| C 17 | 1nF5 | C 18 | 10 nf |
| C 19 | 100 pF | C 22 | 10 $\mu$F |
| C 23 | 100 pF | C 24 | 100 nF |
| C 25 | 100 nF | C 27 | 100 pF |
| C 29 | 10 $\mu$F | CV1 | 22 pF ajustable |
| D 1 | BB0809 ou BB139 | | |
| D 2 | BB0809 ou BB139 | | |
| | | D 3 | BZ X 55C |
| D 4 | IN4148 | D 5 | IN4148 |
| D 7 | IN4148 | | |
| IcAa, IC1b, ICAc IC1d | LM 3086 ou équivalent | | |
| IC2a, IC2b, IC2c IC2d | CD 4066 | | |
| IC3a, IC3b, IC3c IC3d | CD 4069 | | |
| IC4a | CD 4013 | | |
| IC5a, IC5b | CD 4066 | | |
| IC6a, IC6b, IC6c IC6d | CD 4066 | LAR 1 | LAR 330 ns |
| L 1 | 90 $\mu$H | L2 | 47 $\mu$H |
| P 1 | 47 K | T2, T1 | BC307A |
| J 5 | BC 307 A | XV | Platine MU 40 câblée |

## Revendications

1. Codeur SECAM composé d'un circuit générateur de la sous-porteuse CHROMA et d'un circuit de traitement du signal de luminance, caractérisé en ce que le circuit générateur de la sous-porteuse CHROMA comporte un oscillateur (V) de structure symétrique composé de :
— deux diodes (D 2) et (D 1) pour recevoir le signal d'entrée de l'oscillateur, chacune étant reliée à une extrémité d'une bobine ajustable (L 1) ;
— une capacité (C 13) reliée, d'une part à une extrémité de la bobine ajustable (L 1) et, d'autre part, à un transistor suiveur (IC1a), de même une capacité (C 12) est reliée d'une part à l'autre extrémité de la bobine (L 1) et, d'autre part, à un transistor suiveur (IC1d) ;
— une paire de transistors (IC1b) et (IC1c) qui commutent alternativement le courant traversant la résistance (R 25) sur une extrémité de la bobine (L 1) ou sur l'autre extrémité de ladite bobine, la sortie de l'oscillateur se faisant sur un générateur de courant qui ne dépend que de la différence de potentiel aux bornes de la bobine (L 1) ;
— un amplificateur CHROMA (III) utilisant une porte C.MOS (IC3c) associée avec une capacité (C 19) en parallèle sur une résistance (R 29), une capacité (C 18), une résistance variable (P 1), une résistance (R 28), la capacité (C 9) jouant le rôle de préaccentuation.

5

2. Codeur SECAM selon la revendication 1, caractérisé en ce que le signal CHROMA (c) issu du circuit générateur et le signal de luminance (L) issu du circuit de traitement sont amenés à l'entrée du circuit anti-cloche (X) après passage en un point de connexion des sorties des deux circuits où le premier signal est injecté dans le second signal.

**Claims**

1. SECAM coder comprising a generating circuit of the CHROMA subcarrier and a luminance signal processing circuit, characterized in that said CHROMA subcarrier generating circuit includes an oscillator (V) having a symmetrical structure consisting of :
— two diodes (D 2) and (D 1) for receiving the input signal from the oscillator, each diode being connected one terminal of an adjustable coil (L 1) ;
— a capacitor (C 13) connected, on the one hand, to one terminal of said adjustable coil (L 1) and, on the other hand, to a follow-up transistor (IC1a), further a capacitor (C 12) connected, on the one hand, to the other terminal of said coil (L 1) and, on the other hand, to a follow-up transistor (IC1d) ;
— two transistors (IC1b) and (IC1c) which alternatively switch the current flowing through the resistor (R 25) onto one terminal of said coil (L 1) or onto the other terminal of the coil, the output of the oscillator being transmitted to a current generator that only depends on the difference of potential appearing at the terminals of said coil (L 1) ;
— a CHROMA amplifier (III) using a C.MOS gate (IC3c) associated to a capacitor (C 19) mounted in parallel with a resistor (R 29), a capacitor (C 18), an adjustable resistor (P), a resistor (R 28), acting as a pre-accentuation means.

2. SECAM coder according to claim 1, characterized in that the CHROMA signal (c) issuing from the generating circuit and the luminance signal (L) issuing from the processing circuit are transmitted to the input terminal of the anti-bell-shape circuit (circuit anticloche) (X) after passing through a point interconnecting the terminals of the two circuits, where the first signal is injected into the second signal.

**Patentansprüche**

1. SECAM-Verschlüssler, bestehend aus einem CHROMA-Unterträgererzeugerkreis und einem Leuchtkraftsignal-auswertungskreis, dadurch gekennzeichnet, dass der Erzeugerkreis des CHROMA-Unterträgers einen symmetrisch gestalteten Oszillator (V) aufweist, welcher umfasst :
— zwei Dioden (D 2) und (D 1), die das Eingangssignal des Oszillators empfangen, wobei jede dieser Dioden an eine Klemme einer regulierbaren Spule (L 1) angeschlosses ist ;
— einen Kondensator (C 13), der einerseits an eine Klemme der regulierbaren Spule (L 1) und andererseitz an einen Folgetransistor (IC1a) angeschlossen ist, sowie einen Kondensator (C 12), der einerseits an die andere Klemme der Spule (L) und andererseits an einen Folgetransistor (IC1d) angeschlossen ist ;
— zwei Transistoren (IC1b) und (IC1c), die abwechselnd den den Widerstand (R 25) durchfliessenden Strom an eine Klemme der Spule (L 1) oder an an die andere Klemme dieser Spule anlegen, wobei der Ausgang des Oszillators an einen Stromerzeuger angeschlossen ist, der lediglich von der Potentialdifferenz zwischen des Klemmen der Spule (L 1) abhängig ist ;
— einen CHROMA-Verstärker (III) mit einem C.MOS-Gatter (IC3c), welches mit einem zu einem Widerstand (R 29) parallel-geschalteten Kondensator (C 19), einem Kondensator (C 18), einem veränderlichen Widerstand (P 1) und einem Widerstand (R 28) zusammenwirkt, wobei der Kondensator (C 9) die Vorakzentuierung bewirkt.

2. SECAM-Verschlüssler nach Anspruch 1, dadurch gekennzeichnet, dass das aus dem Erzeugerkreis herrührende CHROMA-Signal (C) und das vom Auswertungskreis erzeugte Leuchtkraftsignal (L) an den Eingang des Gegenglokkenformkreises (circuit anticloche) (X) angelegt werden, nachdem sie einen Vernindungspunkt der Ausgänge der beiden Stromkreise durchlaufen haben, an welchem das erste Signal in das zweite Signal eingegeben wird.

# FIG. 1

# FIG. 2